Europäisches Patentamt

European Patent Office

Office européen des brevets

(11) Publication number: **0 438 228 A2**

# EUROPEAN PATENT APPLICATION

(21) Application number: 91300158.2

(22) Date of filing: 09.01.91

(51) Int. Cl.5: **H03K 17/74, H03K 17/76**

(30) Priority: **17.01.90 GB 9001010**

(43) Date of publication of application:
**24.07.91 Bulletin 91/30**

(84) Designated Contracting States:
**DE FR GB**

(71) Applicant: **QUESTECH LIMITED**
**Eastheath Avenue**
**Wokingham Berkshire RG11 2PP(GB)**

(72) Inventor: **Coffey, John Albert**
**10 Orchard Coombe**
**Whitchurch Hill, Reading RG8 7QL(GB)**
Inventor: **Ragheb, Hamid Naim**
**31 Cannock Way**
**Lower Earley, Reading RG6 4EF(GB)**

(74) Representative: **Bubb, Antony John Allen et al**
**GEE & CO. Chancery House Chancery Lane**
**London WC2A 1QU(GB)**

(54) **Switching of logic data signals.**

(57) A data switching device for use in controlling a signal path for relatively low level data logic signals between coupled ECL devices (1,2) comprises a signal input (A) and a signal output (B) between which are connected in series diodes (D1,D2) of reverse polarity. By coupling control potentials to at least the point between the two diodes (D1,D2) and the output (B) of the switch via potential dividers (R3,R1,R5) the diodes (D1,D2) can be biased into a conductive condition allowing the transmission of logic level signals between points A and B. Variation of the potentials in the divider network can be use to render the diodes (D1,D2) non-conductive to block the signal path.

*Fig.1*

## SWITCHING OF LOGIC DATA SIGNALS

This invention relates to the switching of logic data signals, of the kind in which a change of logic state is represented by a change in potential of a predetermined magnitude.

The parallel interface standard for digital television equipment known as EBU 656 specifies Emitter Coupled Logic (ECL) signal levels, wherein a change of logic state is represented by a change between potentials of -0.8v and -1.8v. Therefore within digital television equipment it is often required to select between several of these 8 bit wide parallel data busses for reasons such as input and output signal selection.

Within the ECL logic family there are devices which will serve as data selectors but they have the following disadvantages:

(a) expense relative to other logic families such as TTL or CMOS

(b) high power dissipation.

One solution to these problems is to level shift the incoming ECL data signals to TTL or CMOS levels within the equipment prior to processing the signal and to reconvert back to ECL level at the output. This can lead to implementation problems such as data to clock timing skews which leads to lack of noise immunity. For a simple system such as a 4 input to 2 output selector switch the cost of this solution is also high.

It is accordingly an object of the present invention to provide an improved data selector switching means that overcomes or alleviates one or more of the above-mentioned disadvantages.

The invention accordingly provides a data switching device comprising an input, an output, two diodes connected in series in a signal path between the input and the output, said diodes being connected in reverse polarity such that like poles of both diodes are connected to an intermediate point in said series signal path, and means for coupling at least said intermediate point and said output of the signal path to sources of biasing potential, the arrangement being such that the relationship between the biasing potentials at said intermediate point and said output can be varied between a first state, in which both diodes are biased into a conducting condition and a given variation in signal potential at said input causes a like variation at said output, and a second state in which the signal path between said input and said output is interrupted.

A switching arrangement in accordance with the invention thus provides a simple diode switch matrix which is of low cost and uses low power but which is capable of switching data logic signals such as signals at ECL level, without any level conversion.

Further preferred features of the invention and corresponding advantages thereof will become apparant from the following description taken in conjunction with the drawings and the Claims.

The invention is illustrated by way of example in the drawings in which;

Figure 1 is a circuit diagram of one embodiment of switching device in accordance with the invention,

Figure 2 is a circuit diagram of a further embodiment of switching device in accordance with the invention, and

Figure 3 is a block circuit diagram illustrating a selector switching matrix capable of being formed by the devices of Figs. 1 and 2.

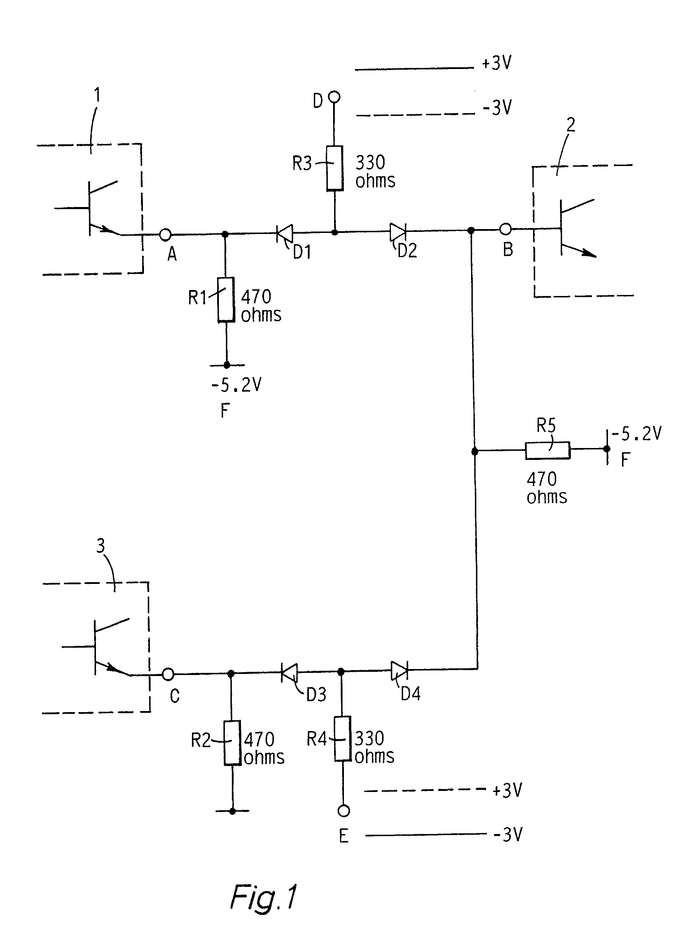

Referring to Fig. 1 there is shown a switching device for use in switching a signal path between an output transistor illustrated diagrammatically at 1, of one stage of equipment and an input transistor illustrated diagrammatically at 2 of another stage of equipment. The transistors 1 and 2 form parts of apparatus adapted to operate at ECL logic levels, i.e. wherein a change in logic state is represented by a swing in signal potential between levels of -0.8v. and -1.8v. The device in accordance with the invention thus provides a signal path between an input A coupled to the emitter of transistor 1 and an output B coupled to the base of transistor 2. Between the input A and output B there are connected in series two signal diodes D1 and D2 the anodes of which are connected together and to one side of a biasing resistor R3, the other side of which is capable of being coupled to two alternate sources of biasing potential, indicated at D.

The cathode of diode D1 is coupled to the input A and to one side of a biasing resistor R1, the other side of which is coupled to a source of biasing potential F, whereas the cathode of diode D2 is likewise coupled to the output B and one side of a biasing resistor R5 the other side of which is coupled to the same source of biasing potential F.

In the illustrated embodiment the source D is capable of being switched between levels of +3v and -3v whereas the source F is maintained at -5.2v, and the biasing resistor R3 has a value of 330 ohms, whereas the biasing resistors R1 and R5 each have values of 470 ohms. It will thus be seen that when the source D is at +3v the resistors R3, R1 and R5 form a potential divider network such that, allowing for the voltage drop across each of the diodes D1 and D2, both the input A and output B of the switch are biased to a voltage level of approximately -0.8v in the absence of application of any other signal potential. The voltage drop provided by the potential divider network is thus such as to hold both of the diodes D1 and D2 in the conductive state so that when the transistor 1 causes a change in logic potential of from -0.8v to -1.8v at the input A, the same logic level change will be reproduced at B without attenuation. However, when the biasing potential D is switched to a level of -3v the voltage drop in the potential divider network R3, R1 and R5 will not be sufficient to maintain the diodes D1 and D2 in a conductive state, and thus the signal path between input A and output B will be blocked.

A further signal path, equivalent to that described above is provided between a transistor 3 and transistor 2, the signal path between the corresponding points C and B likewise including diodes D3 and D4 and being coupled to biasing resistors R2 and R4. The switching of the signal path is effected identically to that described above, and thus will not be described in detail. Suffice it to say that the two signal paths between points A and B and between points C and B can be switched into operation alternatively by applying a potential of +3v at D, whilst applying a potential of -3v at E, and vice versa.

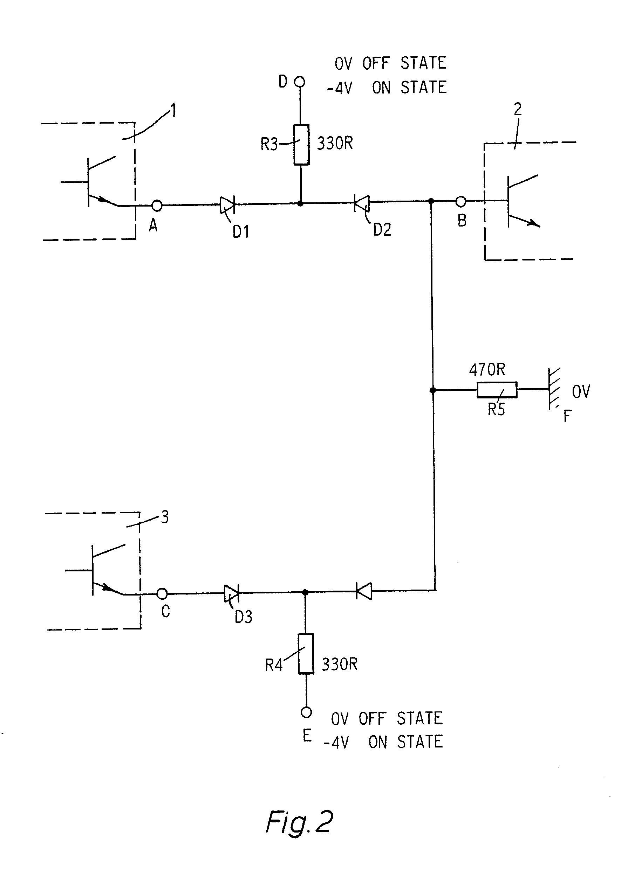

Referring now to Fig. 2, there is shown another embodiment or switching device in accordance with the invention, wherein the same reference numerals as in Fig. 1 are used to illustrate like parts.

The circuit of Fig. 2 differs from that of Fig. 1 only in that the polarity of the respective diodes D1 to D4 is reversed, and the biasing resistors R1 and R2 are omitted. The levels of biasing potential to be applied at points D, E and F are also changed, the biasing potential at point F being 0v and the potentials at points D and E being capable of being switched between 0v and -4v respectively for the off and on states of the respective switching paths.

It will be seen that the operation of the switching device illustrated in Fig. 2 is complementary to that in Fig. 1, in that the values of the biasing potentials are such that when point D is held at -4v a potential divider network will be formed biasing diode D2 into the on condition with the potential at the output B of the switch being held at approximately -1.8v when the signal path is in an idle condition. The potentials in the divider network are further such that the diode D1 will be biased into a conductive condition when a signal potential of -1.8v is applied at the input A of the switch, so that variations in signal potential of between -0.8v and -1.8v at the input A will likewise appear at the output B of the switch. When the bias potential at point D is switched from -4v to 0v there will again be insufficient biasing potential to hold diode D2 in the conducting condition, and diode D1 will be reversed biased in relation to any ECL signal potential appearing at input A. Thus the signal path between points A and B will be blocked.

As in the case of Fig. 1, the two signal paths between points A and B on the one hand and points C and B on the other hand can be switched into action alternatively by applying the different biasing potentials to points D and E respectively.

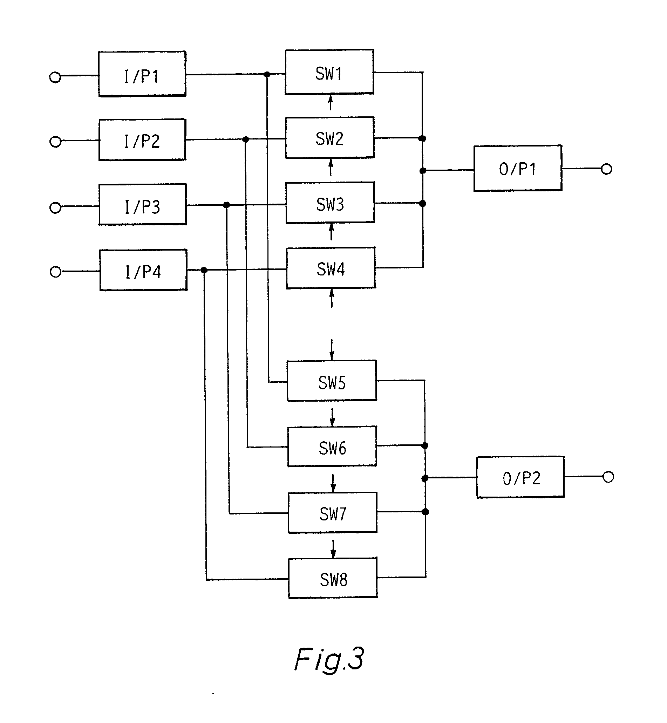

Switching devices as illustrated in Figs. 1 and 2 can be utilised to build up a variety of configurations of switching matrix, one example being illustrated in Fig. 3, wherein the boxes indicated at I/P1 to I/P4 represent input stages of the switch corresponding to transistors 1 or 3 of Fig. 1 or 2, the boxes O/P1 to O/P2 indicate output stages of the switch corresponding to the transistor 2 of Fig. 1 or 2; the boxes indicated at SW1 to SW8 correspond to signal paths between points A and B or points C and B. of Fig. 1 or 2; and the arrows to the respective boxes SW1 to SW8 represent inputs for control potential to a point corresponding to D or E of Fig. 1 or 2.

## Claims

1. A data switching device characterised in that it comprises an input (A), an output (B), two diodes (D1,D2) connected in series in a signal path between the input and the output, said diodes being connected in reverse polarity such that like poles of both diodes are connected to an intermediate point in said series signal path, and means (R2,R1,R5) for coupling at least said intermediate point and said output (B) of the signal path to sources (D,E,F) of biasing potential, the arrangement being such that the relationship between the biasing potentials at said intermediate point and said output (B) can be varied between a first state, in which both diodes (D1,D2) are biased into a conducting condition and a given variation in signal potential at said input (A) causes a like variation at said output (B), and a second state in which the signal path between said input (A) and said output (B) is interrupted.

2. A data selector switching device comprising a plurality of devices according to Claim 1 of which the said outputs (B) are coupled to a common signal bus (O/P1, O/P2), the arrangement being such that the biasing potential to which said intermediate point of each of the signal paths is coupled can be varied selectively to couple any one of said inputs (1/P1,1/P2---) to said common signal bus (O/P1, O/P2).

3. A data selector switching device comprising a plurality of devices according to Claim 1 or 2, (SW1,SW5;SW2,SW6;---) wherein respective inputs of the devices are connected in common to a single signal source (1/P1;---).

4. A device according to any one of Claims 1-3, wherein said means (R3,R1,R5) for coupling to said sources (D,E,F) of biasing potential comprise resistors (R3,R1,R5) coupled between said sources to form a potential divider, and the values of said resistors and said sources of potential are so selected that when said intermediate point is coupled to a given potential source, the potential at said output (B) due to said potential divider (R3,R5) is substantially equal to one of two data signal potential levels to be transmitted by said signal path.

5. A device according to any one of Claims 1-4, wherein said switching device is adapted to transmit ECL logic level signals of between -0.8v and -1.8v.

6. A device according to any one of Claims 1-5, wherein means (R1,R5) are provided for coupling both said input (A) and said output (B) of said signal path to a common source of potential (F) of one polarity, and means (R3) is provided for coupling said intermediate point to two sources of potential (D) of opposite polarity.

7. A device according to any one of Claims 1-5, wherein means (R5) are divided for coupling said output (B) of said signal path to a first potential and means (R3) is provided for coupling said intermediate point either to said first potential or to a second potential.

8. A device according to Claim 7, wherein said first potential is zero volts.

Fig.1

*Fig.2*

*Fig.3*